**Europäisches Patentamt**

**European Patent Office**

**Office européen des brevets**

(19)

(11) Veröffentlichungsnummer: **0 019 887**
**B1**

(12) ## EUROPÄISCHE PATENTSCHRIFT

(45) Veröffentlichungstag der Patentschrift:
**13.04.83**

(51) Int. Cl.³: **H 01 L 23/28,** H 01 L 23/30

(21) Anmeldenummer: **80102901.8**

(22) Anmeldetag: **23.05.80**

(54) **Halbleiterbauelement mit passiviertem Halbleiterkörper.**

(30) Priorität: **30.05.79 DE 2922005**

(43) Veröffentlichungstag der Anmeldung:
**10.12.80 Patentblatt 80/25**

(45) Bekanntmachung des Hinweises auf die Patenterteilung:
**13.04.83 Patentblatt 83/15**

(84) Benannte Vertragsstaaten:
**BE FR GB SE**

(56) Entgegenhaltungen:
**DE-B-1 185 896**
**FR-A-2 359 510**
**FR-A-2 404 992**
**US-A-2 906 932**
**US-A-3 939 488**

(73) Patentinhaber: **SIEMENS AKTIENGESELLSCHAFT,**
**Berlin und München Wittelsbacherplatz 2,**
**D-8000 München 2 (DE)**

(72) Erfinder: **Platzöder, Karl, Dr. rer. nat. Dipl.-Phys.,**
**Grete-Hofmann-Weg 22, D-8041 Haimhausen (DE)**
Erfinder: **Schnöller, Manfred, Dr. rer. nat. Dipl.-Chem.,**
**Grete-Hofmann-Weg 24, D-8041 Haimhausen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Halbleiterbauelement mit passiviertem Halbleiterkörper

Die vorliegende Erfindung bezieht sich auf ein Halbleiterbauelement mit einem Halbleiterkörper, der von einer im wesentlichen isolierende Eigenschaften aufweisenden Hülle umgeben ist, die mindestens teilweise aus einer Kunststoffverguß- oder -preßmasse besteht.

In der deutschen Patentschrift 1 514 531 ist ein Halbleiterbauelement dieser Art beschrieben worden. Der kontaktierte Halbleiterkörper wird dabei in einen Becher eingebracht und mit Kunststoff vergossen. Die Halbleiterelemente können vor dem Vergießen mit einem Lack bedeckt werden.

Beim Umhüllen solcher lackpassivierter Halbleiterkörper mit Kunstharzen, zum Beispiel mit Epoxidharzen oder Silikonpreßmassen, treten Veränderungen der Sperreigenschaften und der Sperrstromstabilität auf. Der Grund ist darin zu sehen, daß aus dem Kunstharz insbesondere während des Erstarrungsvorgangs, aber auch im erstarrten Zustand, elektrisch wirksame Stoffe in die Lackschicht eindringen und bis zur Oberfläche des Halbleiterkörpers wandern.

Aus der DE-A-2 632 647 ist es bekannt, auf die Flächen des Halbleiterkörpers, an denen pn-Übergänge austreten, eine erste Schicht aus amorphem Sauerstoff enthaltenden Silicium und darüber Lack oder Kautschuk aufzubringen.

Aus der US-A-2 906 932 ist es bekannt, die Elektrodenzuführungen einer mit einer Kunststoffvergußmasse umhüllten Halbleiteranordnung in Silikonkautschuk einzubetten.

Der Erfindung liegt die Aufgabe zugrunde, eine Umhüllung für das eingangs erwähnte Halbleiterbauelement anzugeben, bei dem die von der Verguß- oder Preßmasse bewirkte ungünstige Veränderung der Sperreigenschaften und der Sperrstromstabilität vermieden wird.

Diese Aufgabe wird dadurch gelöst, daß die Hülle im Bereich der Flächen des Halbleiterkörpers, an denen pn-Übergänge austreten, aus einer Kombination von drei Schichten ausgebildet ist, daß die erste Schicht amorphes, Sauerstoff enthaltendes Silicium ist, daß auf dieser Schicht als zweite Schicht eine elastische Abdeckschicht aufgebracht ist und daß als dritte Schicht die Kunststoffverguß- oder -preßmasse vorgesehen ist, und daß das Elastizitätsmodul der Abdeckschicht kleiner als das des Halbleiterkörpers und das der Kunststoffmasse ist.

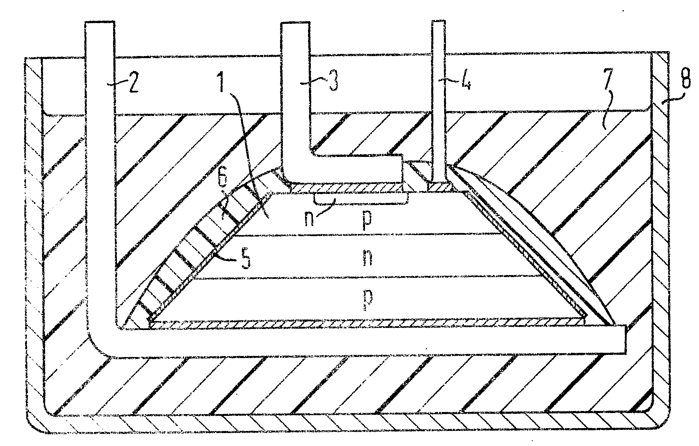

In Fig. 1 ist als Ausführungsbeispiel der Erfindung ein Thyristor im Schnitt dargestellt. Der Thyristor hat einen Halbleiterkörper 1 aus Silicium mit vier Zonen abwechselnden Leitfähigkeitstyps. Die obere Stirnfläche des Halbleiterkörpers 1 ist mit einer Katodenelektrode 3 und einer Steuerelektrode 4 zum Beispiel durch Verlöten verbunden. Die andere Stirnseite ist mit einer Anodenelektrode 2 zum Beispiel ebenfalls durch Verlöten elektrisch und mechanisch verbunden. Die genannten Elektroden werden aus einem Gehäuse herausgeführt, das im wesentlichen aus einem Becher 8 besteht. Die Seitenflächen des Halbleiterkörpers 1 sind von einer Umhüllung umgeben, die aus einer Kombination von drei Schichten besteht: Unmittelbar auf dem Halbleiterkörper 1 ist eine Schicht 5 aufgebracht, die aus sauerstoffhaltigem, amorphem Silicium besteht. Diese Schicht kann beispielsweise 0,05 bis 1 µm dick sein. Auf der Siliciumschicht 5 liegt eine Schicht 6, die aus einem elastischen Abdecklack besteht. Die Schicht 6 wird von einer Kunstharz-Vergußmasse 7 umgeben. Diese Masse kann zum Beispiel aus einem Epoxidharz bestehen.

Der mit der Siliciumschicht 5 und dem elastischen Abdecklack 6 versehene und mit den Elektroden verbundene Halbleiterkörper wird in das Gehäuse eingesetzt und mit der flüssigen Vergußmasse 7 vergossen. Aus der flüssigen Vergußmasse 7 treten dann elektrisch nichtneutrale Stoffe durch den Abdecklack 6 hindurch und gelangen bis zur Siliciumschicht 5. Diese Siliciumschicht 5 ist als hochohmiger Widerstand anzusehen, der die durch den Abdecklack 6 hindurchtretenden Ladungsträger ableitet und ihre Wirkung zumindest weitgehend eliminiert. Eine Verschlechterung der Sperrstromstabilität und der Sperreigenschaften wird damit weitgehend ausgeschlossen.

Der Abdecklack 6 hat ein Elastizitätsmodul, das kleiner als das des Siliciums und das der Vergußmasse ist. Damit können beim Erstarren der Vergußmasse auf den Halbleiterkörper ausgeübte Spannungen vergleichmäßigt werden, so daß eine Beschädigung der Siliciumschicht 5 vermieden wird. Beim Betrieb des Halbleiterbauelements werden somit auch an der Grenzfläche von Halbleiterkörper und Vergußmasse durch Erwärmung des Halbleiterelements auftretende Spannungen so weit vergleichmäßigt, daß eine Beschädigung der Schicht 5 vermieden wird. Damit werden auch im erstarrten Zustand aus der Vergußmasse 7 austretende elektrisch aktive Stoffe zuverlässig von der Oberfläche des Halbleiterkörpers 1 abgeschirmt.

Zweckmäßigerweise ist der elastische Abdecklack ein Silikonkautschuk. Die Vergußmasse kann ein Epoxidharz sein; im Fall der Umpressung des Halbleiterkörpers kann zum Beispiel eine Silikonpreßmasse verwendet werden. Auf Grund der Passivierung durch die amorphe, Sauerstoff enthaltende Siliciumschicht in Verbindung mit dem elastischen Abdecklack können jedoch auch andere, bisher nicht verwendbare Preß- oder Vergußmassen verwendet werden.

Die Siliciumschicht 5 kann zum Beispiel durch Aufdampfen von Silicium im Hochvakuum unter Anwesenheit von Sauerstoff hergestellt sein. Sie kann beispielsweise 0,05 µm dick sein und 4% Sauerstoff enthalten. Sie hat damit einen Widerstand von 2 bis 6 · 10⁸ Ohm · cm. Der Silikonkautschuk kann 0,2 bis zu mehreren mm dick aufgetragen werden. Als Hüllmasse ist dann zum Beispiel ein Epoxidharz verwendbar. Mit dieser Dimensionierung wurde bei einem Thyristor mit einem Halbleiterkörper von 15 mm Durchmesser und 400 µm Dicke eine gute Stabilität der Sperreigenschaften und des Sperrstroms erreicht. Veränderungen des spezifischen Widerstands der amorphen Siliciumschicht können durch Veränderung ihrer Dicke und/oder durch Änderung des Sauerstoffanteils eingestellt werden. Das Verfahren zum Aufbringen einer amorphen Siliciumschicht ist an sich bekannt (siehe zum Beispiel DE-OS 2 632 647), so daß auf weitere Einzelheiten des Aufdampfverfahrens verzichtet werden kann.

**Patentansprüche**

1. Halbleiterbauelement mit einem Halbleiterkörper, der von einer im wesentlichen isolierende Eigenschaften aufweisenden Hülle umgeben ist, die mindestens teilweise aus einer Kunststoffverguß- oder Preßmasse besteht, dadurch gekennzeichnet, daß die Hülle im Bereich der Flächen des Halbleiterkörpers, an denen pn-Übergänge auftreten, aus einer Kombination von drei Schichten besteht, daß die erste Schicht (5) amorphes, Sauerstoff enthaltendes Silicium ist, daß auf dieser Schicht als zweite Schicht (6) eine elastische Abdeckschicht aufgebracht ist und daß als dritte Schicht (7) die Kunststoffverguß- oder Preßmasse vorgesehen ist, und daß das Elastizitätsmodul der Abdeckschicht kleiner als das des Halbleiterkörpers und das der Kunststoffmasse ist.

2. Halbleiterbauelement nach Anspruch 1, dadurch gekennzeichnet, daß die erste Schicht (5) aus im Hochvakuum aufgedampftem Silicium besteht, daß die elastische Abdeckschicht (6) ein Silikonkautschuk ist und daß die Kunststoffmasse (7) ein Epoxidharz oder eine Silikonpreßmasse ist.

**Claims**

1. A semiconductor component having a semiconductor body, which is surrounded by a casing which essentially exhibits insulating properties and consists, at least in part, of a synthetic resin casting or moulding material, characterised in that in the regions of the surfaces of the semiconductor body at which pn-junctions occur, the casing consists of a combination of three layers; that the first layer (5) is amorphous silicon containing oxygen; that on this layer there is applied an elastic covering layer forming the second layer (6); that the synthetic resin casting or moulding material is provided as the third layer (7); and that the modulus of elasticity of the covering layer is smaller than that of the semiconductor body and that of the synthetic resin material.

2. A semiconductor component according to Claim 1, characterised in that the first layer (5) consists of silicon which has been vapour-deposited in high vacuum; that the elastic covering layer (6) is a silicone rubber; and that the synthetic resin material (7) is an epoxy resin, or a silicon moulding material.

**Revendications**

1. Composant à semiconducteurs avec un corps semiconducteur qui est entouré d'une enveloppe présentant des propriétés essentiellement isolantes et qui est constitué au moins en partie par une masse de matière plastique coulable ou moulable, caractérisé par le fait que l'enveloppe est constituée dans la partie des surfaces du corps semiconducteur auxquelles apparaissent des jonctions pn par la combinaison de trois couches, que la première couche (5) est du silicium amorphe et contenant de l'oxygène, que sur cette couche est déposée, comme seconde couche (6), une couche de couverture élastique et que, comme troisième couche (7) est prévue la masse de matière plastique coulable ou moulabe, et que le module l'élasticité de la couche de couverture est inférieur à celui du corps semiconducteur et à celui de la masse de matière plastique.

2. Composant à semiconducteurs selon la revendication, caractérisé par le fait que la première couche (5) est constituée par du silicium déposé par vaporisation dans un vide poussé, que la couche de couverture élastique (6) est un caoutchouc aux silicones et que la masse de matière plastique (7) est une résine époxy ou une masse de montage aux silicones.

n p

n

p